# EUROPEAN PATENT SPECIFICATION

(11) **EP 0 497 431 B1**
(45) Date of publication and mention of the grant of the patent: **28.06.1995**
(21) Application number: 92201060.8
(22) Date of filing: 13.04.1988
(51) Int. Cl.: H01S 3/133

(54) **An apparatus for driving a semiconductor laser device**
Apparat zum Betreiben einer Halbleiterlaservorrichtung
Appareil pour commander un dispositif à laser à semi-conducteur

(30) Priority: 13.04.1987 JP 90168/87; 13.04.1987 JP 90169/87; 13.04.1987 JP 90170/87; 13.04.1987 JP 90171/87; 13.04.1987 JP 90172/87; 05.02.1988 JP 25886/88; 09.03.1988 JP 55747/88
(43) Date of publication of application: 05.08.1992
(62) Divisional of application: 88303348.2
(73) Proprietor: SHARP KABUSHIKI KAISHA, Osaka 545 (JP)
(72) Inventor: Hatanaka, Kazuomi, Ikoma-shi, Nara-ken (JP); Ohno, Takashi, Uda-gun, Nara-ken (JP); Ogou, Kenji, Nara-shi, Nara-ken (JP)
(74) Representative: White, Martin David

(56) References cited:
- EP-A- 0 061 034
- EP-A- 0 096 341
- CA-B- 1 210 070
- US-A- 4 692 606

## Description

### 1. Field of the invention:

This invention relates to an apparatus for driving a semiconductor laser device.

### 2. Description of the prior art:

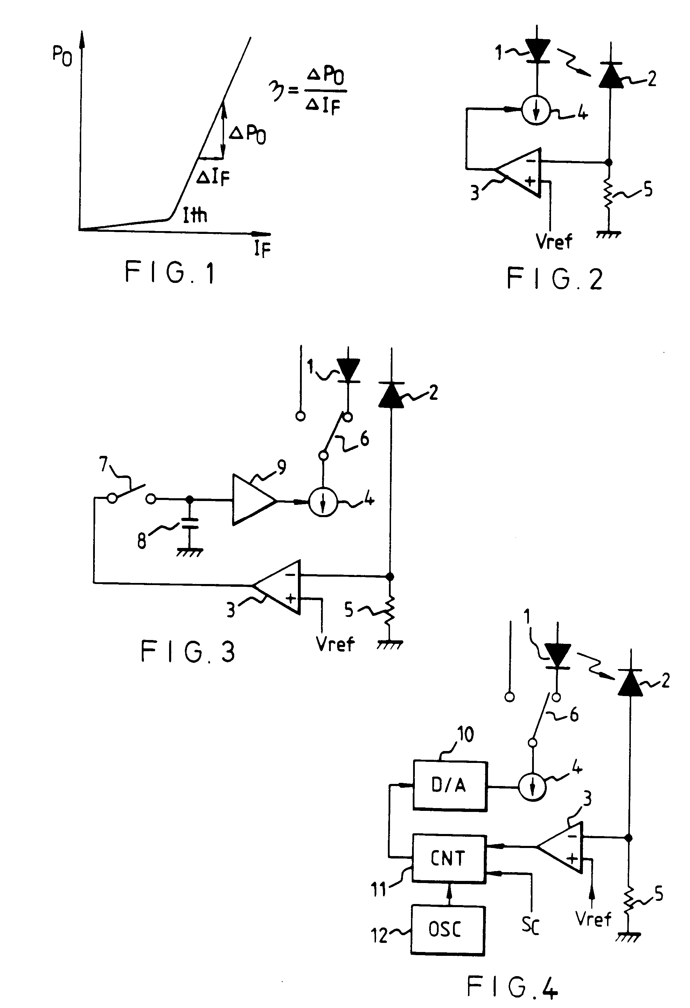

When driving a semiconductor laser device to obtain a laser beam, a forward current I_{F} is supplied to a pn junction in the laser device. The relationship between the forward current I_{F} and the optical output P_{O} of a semiconductor laser device is not linear. As the forward current I_{F} supplied to a semiconductor laser device increases, the laser device begins to oscillate a laser beam at a certain level of the current (a threshold current Iₜₕ). As the forward current I_{F} increases further, the laser output P_{O} also increases. Figure 1 shows an example of the relationship between the forward current I_{F} and the optical output P_{O} of a semiconductor laser device.

The level of a threshold current Iₜₕ and the rate of change in an optical output P_{O} with respect to the changes in a forward current I_{F} are not constant but vary according to an ambient temperature or to the individual semiconductor laser device. Such a rate of change in an optical output P_{O} is called a differential efficiency.

When a semiconductor laser diode is driven at an optical output of a constant level, the system shown in Fig. 2 is generally used. In this system, a semiconductor laser diode 1 is driven by a current source 4 which is controlled by the output of an amplifier 3. The optical output of the laser diode 1 is monitored by a photodiode 2, and is converted into voltage by a resistor 5. The voltage is applied to one input terminal of the amplifier 3. The system shown in Fig. 2 constitutes a negative feedback loop. A reference voltage V_{ref} is applied to the other input terminal of the amplifier 3 so that the optical output of the laser diode 1 is controlled to have a predetermined level corresponding to the reference voltage V_{ref}.

The system shown in Fig. 2 is used for obtaining a constant optical output of a predetermined level. In certain kinds of application of a semiconductor laser diode, such as laser printers or optical communication, a semiconductor laser diode producing a constant optical output of a predetermined level is turned on and off at a high speed. Figure 3 shows an example of a system used for such an application.

The system of Fig. 3 comprises, in addition to the components in the system of Fig. 2, an analog switch 7 and a capacitor 8 which constitute a sample-hold circuit. The system of Fig. 3 further comprises a high-speed switch 6 and a buffer amplifier 9. The operation of the system of Fig. 3 will be described. First, the switch 6 is set to the right position, and the switch 7 is turned on to obtain an optical output of a predetermined level corresponding to the reference voltage V_{ref}. Thereafter, the switch 7 is turned off. At this stage, the voltage applied to the amplifier 9 is held at the voltage level of the capacitor 8 so that the driving current supplied to the laser diode 1 is maintained to be constant. Then, the switch 6 is turned off and on at a high speed, resulting in a high-speed switching of the optical output of a constant level.

With the system shown in Fig. 3, it is difficult to maintain the optical output at a constant level for a long period of time because the voltage of the capacitor 8 is an analog value. The system illustrated in Fig. 4 has been proposed to solve this problem, i.e., the system can maintain the optical output at a constant level for a long period of time.

The system of Fig. 4 is not provided with the sample-hold circuit (the analog switch 7 and capacitor 8) and the buffer amplifier 9 which are used in the system of Fig. 3, but comprises an up/down counter 11, a D/A converter 10, and an oscillator 12. In the system of Fig. 4, the amplifier 3 functions as a comparator. When the output of the comparator 3 is "HIGH", the up/down counter 11 counts up the output pulses of the oscillator 12. When the output of the comparator 3 is "LOW", in contrast, the counter 11 counts down the output pulses of the oscillator 12. The output of the counter 11 is converted into an analog value corresponding to the forward current I_{F} by the D/A converter 10. When the switch 6 is set to the right position, the forward current I_{F} from the current source 4 is supplied to the semiconductor laser diode 1 to drive the laser diode 1. The system of Fig. 4 constitutes a negative feedback loop so that the optical output of the laser diode 1 is regulated at a constant value corresponding to the reference voltage V_{ref}. An error which corresponds to one pulse of the output of the oscillator 12 may occur in the level of the optical output. Such a system is disclosed in EP-A-0 096 341.

A problem is as follows:- in the system of Fig. 4 an optical output of a desired level can be obtained by applying a reference voltage V_{ref} which corresponds to the desired optical output level and closing the negative feedback loop (hereinafter. this process is referred as "calibration"). As the calibration is not directly related to the driving operation of the laser diode 1. it is difficult to employ the system of Fig. 4 in an apparatus in which the optical output level should be changed very frequently. In an optical magnetic disk recording apparatus. for example, the optical output is changed into three levels (reading. erasing, and recording level).

CA-B-1 210 070, on which the preamble of claim 1 is based discloses an apparatus for driving a semiconductor laser device, the apparatus comprising: - current supply means; control means for controlling a current supplied to the laser device by the current supply means, the control means comprising a memory means; monitoring means for monitoring an optical output of the laser device and generating a signal representative of the optical output of the laser device; and comparing means for comparing the signal representative of the optical output with a reference value and providing an output signal, the output signal depending on a comparison of the signal representative of the optical output with the reference value; the memory means being adapted to store a first current value and a first value of the optical output of the laser device, the first value of the optical output of the laser device being obtained when the first current value is supplied to the laser device and to store a second current value and a second value of the optical output of the laser device, the second value of the optical output of the laser device being obtained when the second current value is supplied to the laser device.

However, the apparatus disclosed in CA-B-1 210 070 supplies a bias current (I) to a laser used in a digital data transmission system. The apparatus measures the second derivative of the laser power (L) with respect to the current and sets the current at a value corresponding to a peak in d²L/dI², as this value of the current maximises the ratio of the laser output power for data "1" to the laser output power for data "0". CA-B-1 210 070 does not disclose an apparatus adapted to calculate the current required to obtain a predetermined optical output from the laser device.

### SUMMARY OF THE INVENTION

According to the present invention there is provided an apparatus for driving a semiconductor laser device according to the preamble of claim 1, the apparatus for driving a semiconductor laser device being characterised in that the control means is adapted to calculate a third current value corresponding to a predetermined optical output from the laser device, the third current value being calculated from the stored values; in that it further comprises: - counting means for developing a digital signal for the output signal provided from the comparing means; and D/A converting means for developing a control signal to control the current supply means in response to the digital signal; and in that the monitoring means, the comparing means, the counting means, the control means, the D/A converting means and the current supply means comprise a feedback loop.

Preferably, the control means calculates the third current value using the equation${\text{P}}_{\text{O}} {\text{= η I}}_{\text{F}} \text{+ ξ}$
wherein the constants η and ξ are calculated from the stored values using the following equations:${\text{η = (P}}_{\text{O2}} {\text{- P}}_{\text{O1}} {\text{)/(I}}_{\text{F2}} {\text{- I}}_{\text{F1}} \text{)}$${\text{ξ = (P}}_{\text{O1}} {\text{I}}_{\text{F2}} {\text{- I}}_{\text{F1}} {\text{P}}_{\text{O2}} {\text{)/(I}}_{\text{F2}} {\text{- I}}_{\text{F1}} \text{)}$

Thus, the invention described herein makes possible the objective of providing an apparatus for driving a semiconductor laser diode which can change the optical output to desired levels at a very high frequency.

### BRIEF DESCRIPTION OF THE DRAWINGS

This invention may be better understood and its numerous objects and advantages will become apparent to those skilled in the art by reference to the accompanying drawings as follows:

Figure 1 is a graph showing a relation between a forward current I_{F} and an optical output level of a laser diode.

Figure 2 is a diagram showing an example of a conventional apparatus.

Figure 3 is a diagram showing another example of a conventional apparatus in which a sample-hold circuit is used and the optical output of a laser diode is switched at a high frequency.

Figure 4 is a diagram showing a further example of a conventional apparatus in which a D/A converter is disposed in a feedback loop.

Figure 5 is a diagram of an embodiment of the invention.

Figure 6 is a detailed diagram of the embodiment of Fig. 5.

Figure 7 is a graph for illustrating the operation of the embodiments shown in Figs. 5 and 6.

### Detailed description of preferred embodiments

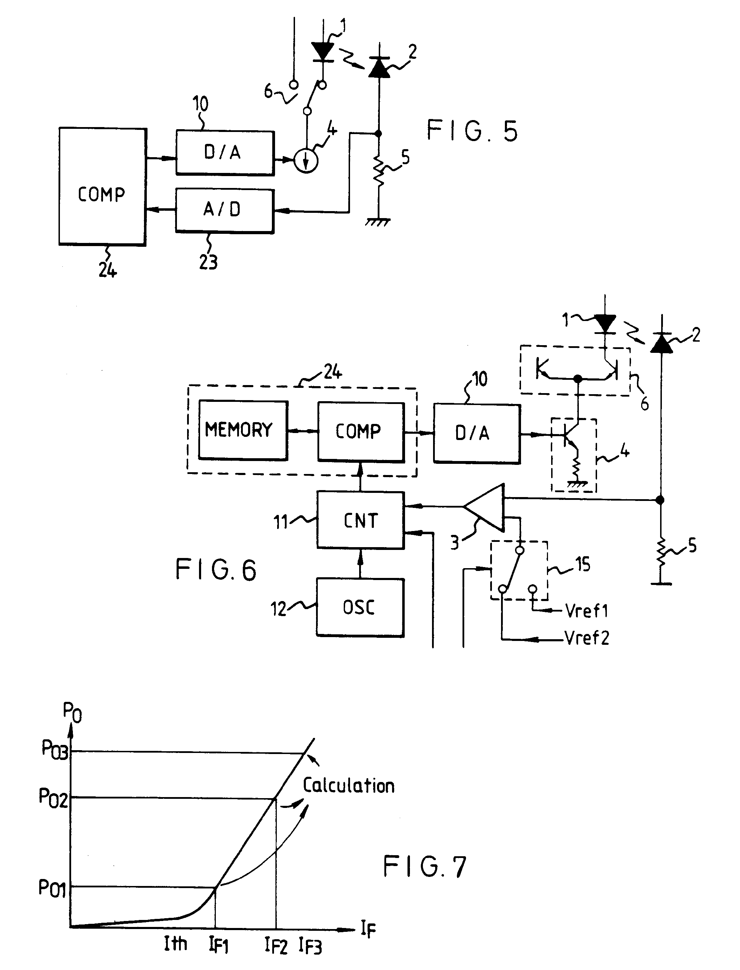

Figure 5 shows diagramatically an embodiment of the invention. In the system of Fig. 5, the monitor signal detected by the circuit consisting of a photodiode 2 and a resistor 5 is converted to digital codes by an A/D converter 23, and sent to a computing means 24. The computing means 24 has a memory. The digital codes from the A/D converter 23 are processed in the computing means 24. The obtained result is fed back to a laser diode 1 through a D/A converter 10, a current source 4, and a switch 6.

The system of Fig. 5 will be described more specifically with reference to Fig. 6. The system of Fig. 6 is constructed so that an optical output of any desired level can be obtained only by conducting the calibration two times. In the example, the A/D converter 23 consists of a comparator 3, an analog switch 15, an up/down counter 11, and an oscillator 12. In the system of Fig. 6, the relationship between the optical output P_{O} and a forward current I_{F} can be calculated by the following Equation (1):${\text{P}}_{\text{O}} {\text{= ηI}}_{\text{F}} \text{+ ζ}$

For example, the calibration is conducted for two optical output levels P_{O1} and P_{O2} to obtain an amount of the forward current I_{F} for each output level. When a value I_{F1} is obtained for the output level P_{O1} and a value I_{F2} for the output level P_{O2}, the constants can be calculated from the following Equations (2) and (3):$\text{η =} \frac{{\text{P}}_{\text{O2}} {\text{- P}}_{\text{O1}}}{{\text{I}}_{\text{F2}} {\text{- I}}_{\text{F1}}}$$\text{ζ =} \frac{{\text{P}}_{\text{O1}} {\text{I}}_{\text{F2}} {\text{- P}}_{\text{O2}} {\text{I}}_{\text{F1}}}{{\text{I}}_{\text{F2}} {\text{- I}}_{\text{F1}}}$
Therefore, a level I_{F3} of the forward current which is required for obtaining an optical output of any desired level P_{O3} can be calculated from the Equation (1). This is illustrated in Fig. 7 .

The operation of the system of Fig. 6 will be described. The values of the two levels P_{O1} and P_{O2} at each of which the calibration is to be conducted are previously stored in the memory of the computing means 24. The calibration is done by applying the reference voltage V_{ref1} or V_{ref2} to the comparator 3. The reference voltages V_{ref1} and V_{ref2} correspond to the optical output levels P_{O1} and P_{O2}, respectively. The output of the counter 11 obtained at each calibration is stored in the memory of the computing means 24. The stored output of the counter 11 corresponds to the forward current I_{F1} or I_{F2} by which the laser diode 1 is driven to emit the optical output of the level P_{O1} or P_{O2}. From the stored data, η and ζ are calculated using the Equations (2) and (3). Then, the system conducts an operation process of driving the laser diode 1. When an optical output of another level P_{O3} is to be emitted, the computing means 24 calculates the value of a forward current I_{F3} which is necessary for obtaining the desired optical output level P_{O3}. This is calculated from Equation (1), and is sent to the D/A converter 10. As easily understood from the above, the feedback loop from the photodiode 2 to the counter 11 is not necessary when driving the laser diode 1. Even when the desired optical output level P_{O3} is rapidly changed, therefore, the system can precisely drive the laser diode 1 at the desired level P_{O3}. The calibration may be conducted when an operating condition affecting the optical output level (for example, an ambient temperature) varies.

As seen from the above-mentioned description of the preferred embodiments, a D/A converter having low resolution which can be easily produced at a low cost can be used in an apparatus of the present invention. Therefore, an apparatus of the present invention can be easily manufactured a low cost and is easily integrated.

It is understood that various other modifications will be apparent to and can be readily made by those skilled in the art without departing from the scope of this invention. Accordinaly, it is not intended that the scope of the invention be limited to the description as set forth herein, but rather by the appended claims.

## Claims

1. An apparatus for driving a semiconductor laser device (1), the apparatus comprising:-
current supply means (4);
control means (24) for controlling a current (I_{F}) supplied to the laser device (1) by the current supply means (4), the control means (24) comprising a memory means;
monitoring means (2) for monitoring an optical output (P_{O}) of the laser device (1) and generating a signal representative of the optical output (P_{O}) of the laser device (1); and
comparing means (3) for comparing the signal representative of the optical output with a reference value and providing an output signal, the output signal depending on a comparison of the signal representative of the optical output with the reference value;
the memory means being adapted to store a first current value (I_{F1}) and a first value (P_{O1}) of the optical output of the laser device (1), the first value (P_{O1}) of the optical output of the laser device (1) being obtained when the first current value (I_{F1}) is supplied to the laser device (1) and to store a second current value (I_{F2}) and a second value (P_{O2}) of the optical output of the laser device (1), the second value (P_{O2}) of the optical output of the laser device being obtained when the second current value (I_{F2}) is supplied to the laser device (1);
the apparatus for driving a semiconductor laser device (1) being characterised in that the control means (24) is adapted to calculate a third current value (I_{F3}) corresponding to a predetermined optical output (P_{O3}) from the laser device, the third current value being calculated from the stored values (I_{F1}, P_{O1}, I_{F2}, P_{O2});
in that it further comprises:-
counting means (11) for developing a digital signal for the output signal provided from the comparing means (3); and
D/A converting means (10) for developing a control signal to control the current supply means (4) in response to the digital signal;
and in that the monitoring means (2), the comparing means (3), the counting means (11), the control means (24), the D/A converting means (10) and the current supply means (4) comprise a feedback loop.

2. An apparatus for driving a semiconductor laser device (1) according to claim 1, wherein the control means calculates the third current value (I_{F3}) using the equation${\text{P}}_{\text{O}} {\text{= η I}}_{\text{F}} \text{+ ξ}$ wherein the constants η and ξ are calculated from the stored values (I_{F1}, P_{O1}, I_{F2}, P_{O2}) using the following equations:${\text{η = (P}}_{\text{O2}} {\text{- P}}_{\text{O1}} {\text{)/(I}}_{\text{F2}} {\text{- I}}_{\text{F1}} \text{)}$${\text{ξ = (P}}_{\text{O1}} {\text{I}}_{\text{F2}} {\text{- I}}_{\text{F1}} {\text{P}}_{\text{O2}} {\text{)/(I}}_{\text{F2}} {\text{- I}}_{\text{F1}} \text{)}$

## Patentansprüche

1. Vorrichtung zum Betreiben eines Halbleiterlaser-Bauteils (1), mit:
- einer Stromversorgungseinrichtung (4);
- einer Steuerungseinrichtung (24) zum Steuern eines dem Laserbauteil (1) durch die Stromversorgungseinrichtung (4) zugeführten Stroms, wobei die Steuerungseinrichtung (24) eine Speichereinrichtung enthält;
- einer Überwachungseinrichtung (2) zum Überwachen der optischen Ausgangsleistung (P_{O}) des Laserbauteils (1) und zum Erzeugen eines Signals, das für die optische Ausgangsleistung (P_{O}) des Laserbauteils (1) repräsentativ ist; und
- einer Vergleichseinrichtung (3) zum Vergleichen des für die optische Ausgangsleistung repräsentativen Signals mit einem Bezugswert und zum Liefern eines Ausgangssignals, das vom Vergleich des für die optische Ausgangsleistung repräsentativen Signals mit dem Bezugswert abhängt;
- wobei die Speichereinrichtung so ausgebildet ist, daß sie einen ersten Stromwert (I_{F1}) und einen ersten Wert (P_{O1}) für die optische Ausgangsleistung des Laserbauteils (1) speichert, wobei der erste Wert (P_{O1}) der optischen Ausgangsleistung des Laserbauteils (1) dann erhalten wird, wenn dem Laserbauteil (1) der Strom mit dem ersten Wert (I_{F1}) zugeführt wird, und sie einen zweiten Stromwert (I_{F2}) und einen zweiten Wert (P_{O2}) der optischen Ausgangsleistung des Laserbauteils (1) speichert, wobei der zweite Wert (PO₂) der optischen Ausgangsleistung des Laserbauteils erhalten wird, wenn das Laserbauteil (1) mit dem Strom vom zweiten Wert (I_{F2}) versorgt wird;
- wobei die Vorrichtung zum Betreiben eines Halbleiterlaser-Bauteils (1) **dadurch gekennzeichnet ist, daß** die Steuerungseinrichtung (24) so ausgebildet ist, daß sie einen dritten Stromwert (I_{F3}) berechnet, der einer vorgegebenen optischen Ausgangsleistung (P_{O3}) des Laserbauteils entspricht, wobei der dritte Stromwert aus den abgespeicherten Werten (I_{F1}, P_{O1}, I_{F2}, P_{O2}) berechnet wird;
- und daß sie ferner folgendes aufweist:
- eine Berechnungseinrichtung (11) zum Erzeugen eines digitalen Signals für das von der Vergleichseinrichtung (3) gelieferte Ausgangssignal; und
- eine D/A-Umsetzeinrichtung (10) zum Erzeugen eines Steuersignals zum Steuern der Stromversorgungseinrichtung (4) auf das digitale Signal hin;
- und daß die Überwachungseinrichtung (2), die Vergleichseinrichtung (3), die Zähleinrichtung (11), die Steuerungseinrichtung (24), die D/A-Umsetzeinrichtung (10) und die Stromversorgungseinrichtung (4) eine Rückkopplungsschleife aufweisen.

2. Vorrichtung zum Betreiben eines Halbleiterlaser-Bauteils (1) gemäß Anspruch 1, bei dem die Steuerungseinrichtung den dritten Stromwert (I_{F3}) unter Verwendugn der folgenden Gleichung berechnet:${\text{P}}_{\text{O}} {\text{= η I}}_{\text{F}} \text{+ ξ}$ wobei die Konstanten η und ζ aus den abgespeicherten Werten (I_{F1}, P_{O1}, I_{F2}, P_{O2}) unter Verwendung der folgenden Gleichungen berechnet werden:${\text{η = (P}}_{\text{O2}} {\text{- P}}_{\text{O1}} {\text{)/(I}}_{\text{F2}} {\text{- 1}}_{\text{F1}} \text{)}$${\text{ζ = (P}}_{\text{O1}} {\text{I}}_{\text{F2}} {\text{- I}}_{\text{F1}} {\text{P}}_{\text{O2}} {\text{)/(I}}_{\text{F2}} {\text{- I}}_{\text{F1}} \text{)}$

## Revendications

1. Appareil pour commander un dispositif laser à semi-conducteur (1), l'appareil comprenant :
un moyen d'alimentation en courant (4) ;
un moyen de commande (24) pour régler un courant (I_{F}) fourni au dispositif laser (1) par le moyen d'alimentation en courant (4), le moyen de commande (24) comprenant un moyen formant mémoire ;
un moyen de contrôle (2) pour contrôler une sortie optique (P_{O}) du dispositif laser (1) et pour générer un signal représentatif de la sortie optique (P_{O}) du dispositif laser (1) ; et
un moyen comparateur (3) pour comparer le signal représentatif de la sortie optique avec une valeur de référence et pour fournir un signal de sortie, le signal de sortie étant fonction d'une comparaison du signal représentatif de la sortie optique avec la valeur de référence ;
le moyen formant mémoire étant adapté pour mémoriser une première valeur de courant (I_{F1}) et une première valeur (P_{O1}) de la sortie optique du dispositif laser (1), la première valeur (P_{O1}) de la sortie optique du dispositif laser (1) étant obtenue lorsque la première valeur de courant (I_{F1}) est fournie au dispositif laser (1), et pour mémoriser une seconde valeur de courant (I_{F2}) et une seconde valeur (P_{O2}) de la sortie optique du dispositif laser(1), la seconde valeur (P_{O2}) de la sortie optique du dispositif laser étant obtenue lorsque la seconde valeur de courant (I_{F2}) est fournie au dispositif laser (1) ;
l'appareil pour commander un dispositif laser à semiconducteur (1) étant caractérisé en ce que le moyen de commande (24) est adapté pour calculer une troisième valeur de courant (I_{F3}) correspondant à une sortie optique prédéterminée (P_{O3}) à partir du dispositif laser, la troisième valeur de courant étant calculée à partir des valeurs (I_{F1}, P_{O1}, I_{F2}, P_{O2}) mémorisées ;
en ce qu'il comprend, en outre :
un moyen de comptage (11) destiné à développer un signal numérique pour le signal de sortie fourni à partir du moyen comparateur (3) ; et
un moyen convertisseur numérique/analogique (10) destiné à développer un signal de commande pour commander le moyen d'alimentation en courant (4) en réponse au signal numérique ;
et en ce que le moyen de contrôle (2), le moyen comparateur (3), le moyen de comptage (11), le moyen de commande (24), le moyen convertisseur numérique/analogique (10) et le moyen d'alimentation en courant (4) constituent une boucle de réaction.

2. Appareil pour commander un dispositif laser à semi-conducteur (1) selon la revendication (1), dans lequel le moyen de commande calcule la troisième valeur de courant (I_{F3}) à l'aide de l'équation${\text{P}}_{\text{O}} {\text{= η I}}_{\text{F}} \text{+ ξ}$ dans laquelle les constantes η et ξ sont calculées à partir des valeurs (I_{F1}, P_{O1}, I_{F2}, P_{O2}) mémorisées à l'aide des équations suivantes :${\text{η = ( P}}_{\text{O2}} {\text{- P}}_{\text{O1}} {\text{) / (I}}_{\text{F2}} {\text{- I}}_{\text{F1}} \text{)}$${\text{ξ = (P}}_{\text{O1}} {\text{I}}_{\text{F2}} {\text{- I}}_{\text{F1}} {\text{P}}_{\text{O2}} {\text{) / (I}}_{\text{F2}} {\text{- I}}_{\text{F1}} \text{)}$
